**Europäisches Patentamt**

**European Patent Office**

**Office européen des brevets**

(19)

(11) Veröffentlichungsnummer: **0 065 579**
**B1**

(12) # EUROPÄISCHE PATENTSCHRIFT

(45) Veröffentlichungstag der Patentschrift:
**14.08.85**

(21) Anmeldenummer: **81103921.3**

(22) Anmeldetag: **21.05.81**

(51) Int. Cl.⁴: **G 01 R 33/02**

(54) Magnetfeldsonde zur Bestimmung eines schwachen Magnetfeldes nach Grösse und Richtung.

(43) Veröffentlichungstag der Anmeldung:
**01.12.82 Patentblatt 82/48**

(45) Bekanntmachung des Hinweises auf die Patenterteilung:
**14.08.85 Patentblatt 85/33**

(84) Benannte Vertragsstaaten:
**AT BE CH FR GB IT LI NL SE**

(56) Entgegenhaltungen:
**AT - B - 244 443**
**DE - A - 2 539 455**
**DE - A - 2 851 415**
**GB - A - 599 428**
**US - A - 2 379 716**
**US - A - 2 390 051**
**US - A - 2 468 554**
**US - A - 2 480 265**
**US - A - 2 491 736**
**US - A - 3 040 247**

(73) Patentinhaber: **Siemens Aktiengesellschaft, Berlin und München Wittelsbacherplatz 2, D-8000 München 2 (DE)**

(72) Erfinder: **Metzner, Uwe, Theodolindenstrasse 49, D-8000 München 90 (DE)**
Erfinder: **Thilo, Peer, Dr.-Ing., Buchhierlstrasse 19, D-8000 München 71 (DE)**

## Beschreibung

Die Erfindung betrifft eine Magnetfeldsonde gemäss dem Oberbegriff des Patentanspruchs 1.

Zur Bestimmung der Richtung eines Magnetfeldes, vorzugsweise des Erdfeldes, wird meist ein Kompass verwendet, bei dem sich eine Magnetnadel parallel zum Erdfeld einstellt. Zur Feldstärkenmessung werden häufig Magnetsonden verwendet, wie sie beispielsweise aus der US-PS 3 040 247 bekannt sind.

Aus dem Vergleich der mit zwei rechtwinklig zueinander in einer horizontalen Ebene angeordneten Sonden gemessenen Feldstärke lässt sich mit trigonometrischen Methoden die Magnetfeldrichtung errechnen. Auf diese Weise ist es möglich, einen «Kompass» ohne bewegte Teile zu schaffen, der ein codiertes elektrisches Ausgangssignal liefert, das eine Funktion der Magnetfeldrichtung ist.

In der DE-OS 2 539 455 ist ein Kompasssystem beschrieben, das eine Magnetfeldsonde verwendet. Die bekannte Magnetfeldsonde weist einen mehrschichtigen Kern auf, der von drei unter gleichen Winkeln in Radialrichtung angeordneten laminierten Schenkeln gebildet ist. Dabei ist im Zentrum eine Erregerspule derart angeordnet, dass ihre Achse senkrecht zu den Achsen der Spulenwicklungen auf den Schenkeln ist. Dazu sind die Schenkel des Kerns mehrfach abgewinkelt. An den oberen und unteren Armen jedes Schenkelkerns sind bogenförmige Kollektorhörner mittels Befestigungselementen montiert, um einen grossflächigen Ein- bzw. Austrittsquerschnitt für den magnetischen Fluss zu erreichen. Die bekannte Magnetfeldsonde weist einen komplizierten mechanischen Aufbau auf und erfordert zudem einen grossen Montageaufwand. Ausserdem erfordert die bekannte Magnetfeldsonde eine kompliziertere Auswertung zur Ermittlung der Richtung eines Magnetfeldes.

Aufgabe der Erfindung ist es, diese Nachteile zu vermeiden und eine Magnetfeldsonde zur Bestimmung der Grösse und Richtung eines schwachen Magnetfeldes so auszugestalten, dass sie kostengünstig ohne grossen Montageaufwand gefertigt werden kann.

Diese Aufgabe wird erfindungsgemäss bei einer eingangs beschriebenen Magnetfeldsonde durch die Merkmale des Kennzeichens des Anspruchs 1 gelöst.

Die erfindungsgemässe Ausgestaltung der Magnetfeldsonde weist entweder vier kreuzförmig verbundene Stege oder vier die Seiten eines Parallelogramms definierende Stege auf, wobei an den freien Enden der Stege sich die verbreiterten Polflächen befinden. Diese können spatenförmig ausgebildet sein; sie weisen jedoch jeweils eine wesentlich grössere Breite auf als die Breite der Stege. Die kreuzförmig ausgebildete Magnetfeldsonde weist eine symmetrische Anordnung auf, die neben einer einfachen Fertigung auch leicht und billig aufzubringende Wicklungen erlaubt. Die jeweils koaxial liegenden Spulenwicklungen sind elektrisch miteinander verbunden. Bei dieser Ausführungsform ist eine offene Wickelfläche gegeben. Diese Ausführungsform der Magnetfeldsonde weist aber grössere Dimensionen auf gegenüber der Ausführungsform mit den vier Stegen, die ein Parallellogramm bilden.

Die erfindungsgemässe Magnetfeldsonde hat den Vorteil, dass die Sonde ohne grossen Montageaufwand hergestellt werden kann. Eine derartig ausgestaltete Sonde weist nur ein dünnes Kernblech auf, das einfach und preisgünstig gefertigt werden kann. Am Kernblech ist keine weitere Montage erforderlich, wie beispielsweise Mehrfachschichtung, Abwinkeln des Blechkerns und zusätzliche Kernbleche, um die Polflächen zu vergrössern.

In einer zweckmässigen Ausgestaltung hat die Magnetfeldsonde die Form eines Quadrats. Diese in sich vollkommen symmetrische Sonde ist sehr klein und ermöglicht eine hohe Messgenauigkeit und eine präzise Richtungsbestimmung. Dabei sind auch die Polflächen quadratisch ausgebildet. Die geschlossene Wickelfläche bedingt allerdings eine etwas teurere Herstellung der Spulenwicklung. Jeweils achsenparallele Spulenwicklungen sind elektrisch miteinander verbunden.

Anhand der Zeichnung wird die Erfindung an zwei Ausführungsformen kurz beschrieben, dabei zeigen die

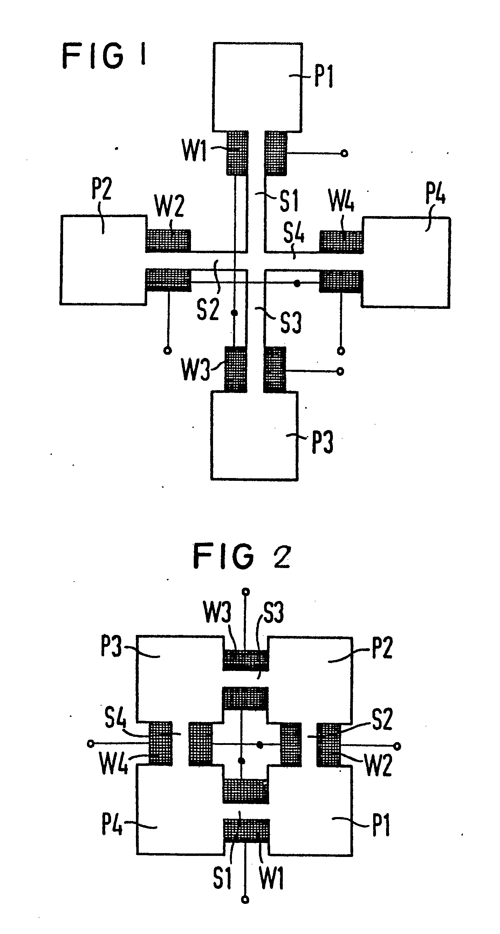

Fig. 1 und 2 eine erfindungsgemässe Magnetfeldsonde.

Fig. 1 zeigt eine kreuzförmige Magnetfeldsonde. Hier besteht das Kernblech aus vier kreuzförmig im rechten Winkel zueinander verbundenen Stegen S1 bis S4 mit je einer Spulenwicklung W1 bis W4. Die vier Enden des Kernblechs weisen ausserhalb der Wicklungen vier grosse quadratische Polflächen P1 bis P4 auf. Zur Erfassung der jeweiligen Magnetfeldkomponenten sind jeweils zwei koaxial angeordnete Wicklungen W1 und W3 bzw. W2 und W4 zu je einer Wicklungseinheit elektrisch verbunden.

Fig. 2 zeigt eine quadratische Magnetfeldsonde. Die vier Stege S1 bis S4 mit je einer Wicklung W1 bis W4 bilden mit den vier quadratischen Polflächen P1 bis P4 als Ecken ein Quadrat. Die Spulenwicklung W1 ist mit der Spulenwicklung W3 und die Wicklung W2 mit der Wicklung W4 zu jeweils einer Wicklungseinheit zur Erfassung je einer Magnetfeldkomponente elektrisch verbunden.

## Patentansprüche

1. Magnetfeldsonde zur Bestimmung eines schwachen Magnetfeldes nach Grösse und Richtung, insbesondere des Erdfeldes, mit einem Kernblech, das mehrere, einen bestimmten Winkel miteinander einschliessende, schmale Stege mit jeweils einer auf diesen angeordneten Spulenwicklung und an den Stegen angebrachte grossflächige Polenden für den Ein- und Austritt des magnetischen Flusses aufweist, dadurch gekennzeichnet, dass die Polenden (P1 bis P4) und die Stege (S1 bis S4) in einer Ebene liegen und von einem einzigen flachen Kernblech gebildet sind, dass die Polenden als spatenförmige Polflächen ausgebildet sind, deren jeweilige Breite wesentlich grösser als die Breite der Stege ist, dass das Kernblech vier Polflächen und vier Stege mit jeweils einer Spulenwicklung (W1 bis W4) aufweist, wobei die vier Stege mit den jeweiligen Polflächen entweder derartig kreuzförmig angeordnet sind, dass jeweils ein Arm des Kreuzes aus einem Steg und der an dessen freiem Ende angeordneten Polfläche besteht, oder die Seiten eines Parallelogramms bilden mit jeweils einer Polfläche an jeder Ecke.

2. Magnetfeldsonde nach Anspruch 1, dadurch gekennzeichnet, dass die einzelnen Polflächen des Kernblechs die Form eines Quadrats aufweisen und die Stege mittig an einer Seite der quadratförmigen Polflächen angeordnet sind.

3. Magnetfeldsonde nach Anspruch 1 oder 2, dadurch gekennzeichnet, dass die vier Stege des Kernblechs mit den jeweiligen Polflächen die Seiten eines Quadrats bilden.

4. Magnetfeldsonde nach Anspruch 1 oder 2, dadurch gekennzeichnet, dass jeweils koaxial liegende Spulenwicklungen elektrisch miteinander verbunden sind.

5. Magnetfeldsonde nach einem der Ansprüche 1 bis 3, dadurch gekennzeichnet, dass jeweils achsparallel liegende Spulenwicklungen elektrisch miteinander verbunden sind.


### Claims

1. A probe for determining the intensity and direction of a weak magnetic field, in particular of the earth's field, comprising a core lamination which has a plurality of narrow cross-pieces which form a specific angle with one another and have respective coil windings arranged thereon, and large-area pole tips fixed to the cross-pieces and serving for the entry and exit of the magnetic flux, characterised in that the pole tips (P1 to P4) and the cross-pieces (S1 to S4) are arranged in one plane and are formed by a single flat core lamination; that the pole tips are designed as spade-shaped pole surfaces, the width of which is in each case substantially greater than the width of the cross-pieces; that the core lamination has four pole surfaces and four cross-pieces with, in each case, a coil winding (W1 to W4), the four cross-pieces with the respective pole surfaces being either arranged in the form of a cross in such a way that each arm of the cross consists of one cross-piece and the pole surface which is arranged at the free end thereof, or forming the sides of a parallelogram with a pole surface at each corner.

2. A magnetic field probe as claimed in Claim 1, characterised in that the individual pole surfaces of the core lamination are in the form of a square and the cross-pieces are centrally arranged at one side of the square pole surface.

3. A magnetic field probe as claimed in Claim 1 or 2, characterised in that the four cross-pieces of the core lamination with the respective pole surface form the sides of a square.

4. A magnetic field probe as claimed in Claim 1 or 2, characterised in that in each case, coaxially arranged coil windings are electrically connected to one another.

5. A magnetic probe als claimed in one of Claims 1 to 3, characterised in that in each case, coil windings with parallel axes are electrically connected to one another.


### Revendications

1. Sonde de champ magnétique pour déterminer un champ magnétique faible en grandeur et direction, en particulier le champ terrestre, comprenant une tôle de noyau qui présente plusieurs barrettes étroites renfermant un angle déterminé entre elles, sur chacune desquelles est disposé un enroulement formant bobine, et avec des extrémités polaires de grande surface disposées sur les barrettes pour l'entrée et la sortie du flux magnétique, caractérisée en ce que les extrémités polaires (P1 à P4) et les barrettes (S1 à S4) sont situées dans un plan et sont formées d'une seule tôle de noyau plane, que les extrémités polaires sont réalisées comme des surfaces polaires en forme de bêches, ayant chacune une largeur nettement plus grande que la largeur des barrettes, que la tôle de noyau présente quatre surfaces polaires et quatre barrettes avec chaque fois un enroulement formant bobine (W1 à W4), les quatre barrettes avec les surfaces polaires correspondantes étant disposées, soit en forme de croix, de manière que chaque branche de la croix se constitue d'une barrette et de la surface polaires disposée à son extrémité libre, soit de manière à former les côtés d'une parallélogramme avec une surface polaire à chaque angle.

2. Sonde de champ magnétique selon la revendication 1, caractérisée en ce que les différentes surfaces polaires de la tôle de noyau ont la forme d'un carré et les barrettes sont disposées au milieu d'un côté des surfaces polaires carrées.

3. Sonde de champ magnétique selon la revendication 1 ou 2, caractérisée en ce que les autre barrettes de la tôle de noyau avec les surfaces polaires correspondantes forment les côtés d'un carré.

4. Sonde de champ magnétique selon la revendication 1 ou 2, caractérisée en ce que les enroulements formant bobines disposés coaxialement sont chaque fois connectés électriquement l'un à l'autre.

5. Sonde de champ magnétique selon une des revendications 1 à 3, caractérisée en ce que les enroulements formant bobines à axes parallèles sont chaque fois connectés électriquement l'un à l'autre.

# FIG 1

# FIG 2